Europäisches Patentamt

(19) European Patent Office

Office européen des brevets

(11) EP 0 846 954 A1

(12) EUROPEAN PATENT APPLICATION

(43) Date of publication:
10.06.1998 Bulletin 1998/24

(51) Int. Cl.$^6$: G01R 29/22

(21) Application number: 96119596.3

(22) Date of filing: 06.12.1996

(84) Designated Contracting States:
CH DE FR GB LI

(71) Applicant:
DAEWOO ELECTRONICS CO., LTD
Seoul (KR)

(72) Inventor: Kim, Dong-Guk
Daejeon (KR)

(74) Representative:
Weitzel, Wolfgang, Dr.-Ing.
Friedenstrasse 10
89522 Heidenheim (DE)

(54) **Method and apparatus for measuring a piezoelectric constant of a thin film type piezoelectric material**

(57) After a computing member, a pressure gauge, a charge measuring member, and a pressing member are initialized, the piezoelectric material (320) is positioned on a supporting member (325). A pressing probe (340) is positioned above a top electrode (340) of the piezoelectric material, to cover the top electrode. The pressing member for applying a pressure to the piezoelectric material is operated, and a main valve (370) is opened. The pressure is applied to the piezoelectric material from the pressing member through the pressing probe. A release valve (360) for changing the applied pressure is adjusted while the main valve is open. A charge generated from the piezoelectric material is measured by the charge measuring member. The magnitudes of the measured charge and the applied pressure recorded in the computing member. The piezoelectric constant of the piezoelectric material is calculated from the recorded magnitudes of charge and pressure by the computing member. Therefore, the piezoelectric constant can be measured by using a pneumatic loading method and by applying a uniform force to the whole surface of the piezoelectric material regardless of a topology of the piezoelectric material, without causing a short or a plastic deformation.

FIG. 4

EP 0 846 954 A1

## Description

<u>Background of the Invention</u>

1. Field of the Invention

The present invention relates to a method for measuring a piezoelectric constant of thin film type piezoelectric material and an apparatus for performing the same, and more particularly to a method for measuring a piezoelectric constant of a thin film type piezoelectric material which can exactly measure a piezoelectric constant of a thin film type piezoelectric material by applying an uniform force to the whole surface of the thin film type piezoelectric material regardless of a topology of the thin film, without causing a short in the thin film or a plastic deformation of the thin film, and an apparatus for performing the same.

2. Prior Art

Electronic devices such as micro-processors and memories have been miniaturized, so their performances have improved and their prices have strongly decreased. There is a similar need to miniaturize mechanical devices such as actuators, and an additional need for micro-actuators for future applications, for example, medical and biomedical. In general, micro-mechanical devices can be based on the electrostatic, piezoelectric, thermal, or electromagnetic principle.

A piezoelectric actuator converts mechanical energy into electrical energy via the piezoelectric effect, or converts electrical energy into mechanical energy via the inverse piezoelectric effect. Namely, the piezoelectric actuator converts electrical energy into mechanical energy by contraction or expansion of a piezoelectric material therein according to the orientation of applied voltage and internal polarization of the piezoelectric material. The construction or expansion of the piezoelectric material is not determined by the dimensions of the piezoelectric material, but by the magnitude and orientation of the applied voltage. Therefore, a piezoelectric thin film can be used to fabricate the micro-actuator. The maximum elongation of piezoelectric thin film is restricted by breakdown field or maximum stress. Hence, the micro actuator having the piezoelectric thin film is generally operated at a low voltage range below 10V.

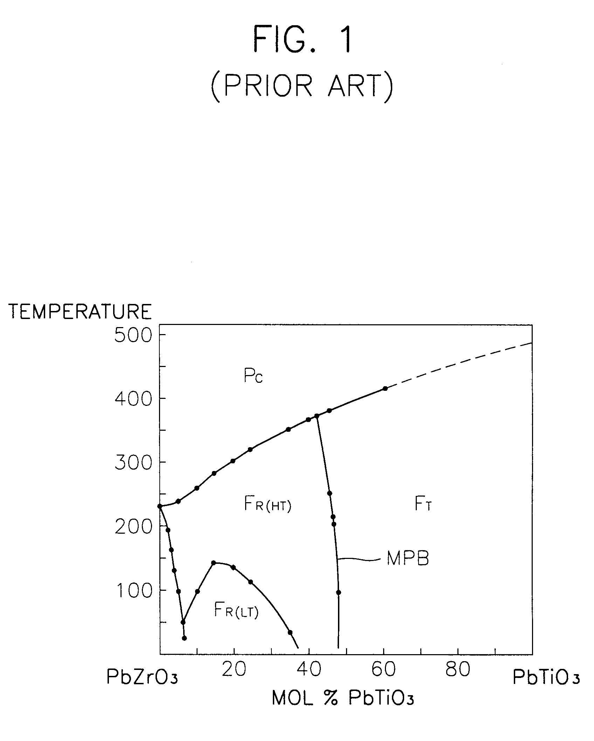

The piezoelectric actuator can be fabricated at a low cost by using the silicon technology. Various applications of piezoelectric thin film integrated on a silicon substrate are known. In most cases, ZnO is used as the piezoelectric thin film. However, lead zirconate titanate (PZT:Pb(Zr,Ti)$O_3$) has a better piezoelectric property than ZnO. PZT is a complete solid solution of lead zirconate (PbZr$O_3$) and lead titanate (PbTi$O_3$). PZT having a cubic structure exists in a paraelectric phase at a high temperature. Orthorhombic structure PZT exists in an antiferroelectric phase, rhombohedral structure PZT exists in a ferroelectric phase, and tetragonal structure PZT exists in a ferromagnetic phase according to the composition ratio of Zr and Ti at a room temperature. FIG. 1 shows a binary phase diagram of PZT. Referring to FIG. 1, a morphotropic phase boundary (MPB) of the tetragonal phase and the rhombohedral phase exists as a composition which includes Zr:Ti at a ratio of 1:1. PZT has a maximum dielectric property and a maximum piezoelectric property at the MPB. The MPB exists in a wide region in which the tetragonal phase and the rhombohedral phase coexist, but does not exists at a certain composition. Researchers do not agree about the composition of the phase coexistent region of PZT. Various theories such as thermodynamic stability, compositional fluctuation, and internal stress have been suggested as the reason for the phase coexistent region.

Nowadays, PZT thin film is manufactured by various processes such as spin coating, organometallic chemical vapor deposition (OMCVD), and sputtering. It is reported that a method for measuring a piezoelectric constant of PZT thin film by measuring the amount of charge generated from the PZT thin film because of applying force to the PZT thin film (see: Measurement of Piezoelectric Coefficient of Ferroelectric Thin Films by K. Lefki and G. J. M. Dormans, J. Appl. Phys. 76 (3), 1 August 1994, pp1764-1767).

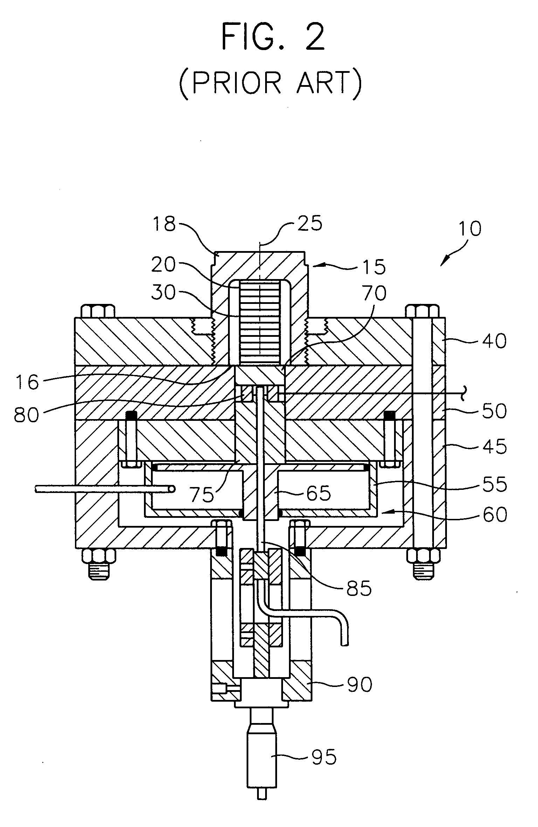

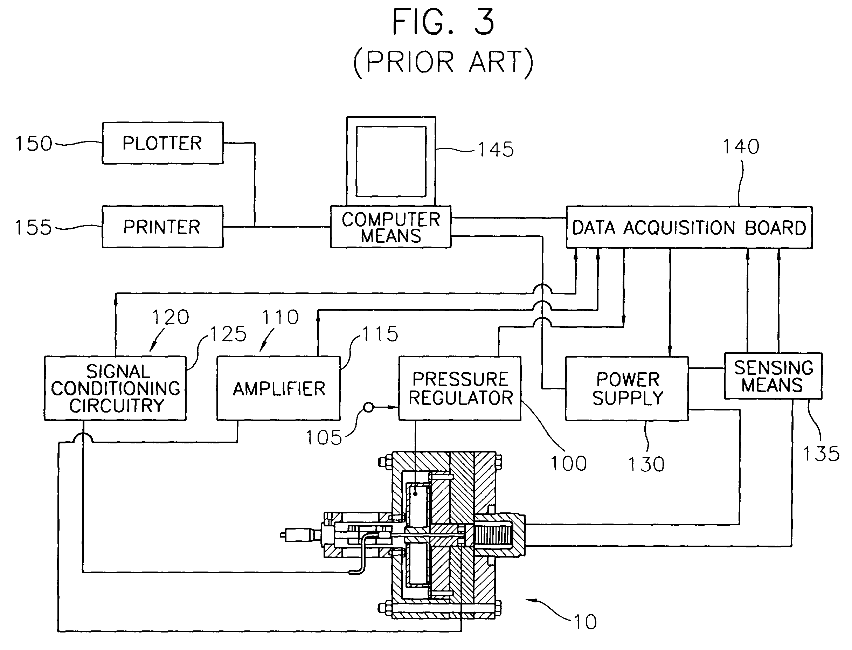

The electrical property of piezoelectric thin film is determined by an elastic constant, a piezoelectric constant, and a dielectric constant. Generally, the piezoelectric constant means an electrical activity level of piezoelectric material. For example, the piezoelectric constant means an expansion or contraction magnitude of a piezoelectric material corresponding to an applied electric field. An apparatus for testing properties of multilayer piezoelectric actuator such as piezoelectric constant, Young's modulus, and capacitance, is disclosed in U.S. Patent No. 5,301,558 (issued to Jeffrey A. Livingstone et al.). FIG. 2 is a cross sectional view for showing the apparatus for testing piezoelectric properties of the multilayer piezoelectric actuator, and FIG. 3 shows a block diagram of the control circuitry associated with the testing apparatus.

Referring to FIG. 2, the testing apparatus 10 has a piezoelectric actuator 15 having a housing 18 and a plurality of piezoelectric elements 20 formed in a column having a length, $L_1$. Housing 18 includes a diaphragm 16 attached to an end of housing 18. Housing 18 protects actuator 15 and is used to mount actuator 15 to testing apparatus 10. The plurality of piezoelectric elements 20 are aligned with an axis 25. Each of piezoelectric elements 20 is shaped of a disk having a cross sectional area, A. Metallic electrodes 30 are interleaved among the plurality of piezoelectric elements 20. Piezoelectric elements 20 are expanded axially, proportional to the magnitude of applied electrical energy. Thus, actuator 15 having piezoelectric elements 20 converts electrical energy into mechanical energy.

Referring to FIG. 2, testing apparatus 10 has a front plate 40, a rear plate 45, and an intermediate plate 50, which are made of hardened steel. Front plate 40 receives actuator 15 and rear plate 45 defines a cavity 55. A pneumatic cylinder 60 having a piston 65 therein is disposed within cavity 55 and is rigidly attached to intermediate plate 50. Front plate 40, intermediate plate 50, and pneumatic cylinder 60 define a central bore axially aligned with housing 18. A cylindrical plate 70 is disposed within the central bore of front plate 40, to lie adjacent to diaphragm 16 of housing 18. For example, cylindrical plate 70 is made of a high tensile steel and one end of cylindrical plate 70 defines a polished surface.

A steel pillow 75 is disposed within the central bore of intermediate plate 50 and pneumatic cylinder 60. One end of pillow 75 is adjacent to piston 65 of pneumatic cylinder 60. A load cell 80 is disposed between the other end of pillow 75 and cylindrical plate 70. Load cell 80 is formed in a shape of a cylindrical ring, and is coaxially disposed about axis 25. Pillow 75 and piston 65 define a small bore axially aligned with axes 25. A fiber optic sensor 85 is disposed within the small bore. Fiber optic sensor 85 has a sensor head located intermediate the polished surface of cylindrical plate 70. As shown in FIG. 2, a sensor housing 90 is fixedly attached to rear plate 45. Sensor housing 90 includes a micrometer 95 adapted to adjust the sensor head invariable proximity to cylindrical plate 70.

Referring to FIG. 3, a proportional pressure regulator 100 is connected to a source of pressurized air 105. Proportional pressure regulator 100 controllably supplies pressurized air to pneumatic cylinder 60. Proportional pressure regulator 100 applies an axial force to actuator 15 in response to the received pressurized air. A load member 110 measures the applied force on actuator 15 and responsively produces a force signal, $F_n$. Load member 110 includes load cell 80 and a dual mode amplifier 115. Load cell 80 measures the applied force on actuator 15 and responsively produces a sense signal. Dual mode amplifier 115 receives and conditions the sense signal, to produce the force signal, $F_n$, having a predetermined voltage range. An optical member 120 measures a linear displacement of actuator 15 and responsively produces a position signal, $L_n$. Optical member 120 includes sensor 85 and associated signal conditioning circuitry 125. Sensor 85 emits random light onto the polished surface of cylindrical plate 70 and senses the reflected light, to responsively produce an optical signal. Signal conditioning circuitry 125 receives the optical signal and transposes the optical signal to the position signal, $L_n$, having a voltage level proportional to the magnitude of the optical signal.

A high voltage power supply 130 delivers constant voltage levels to actuator 15. A sensing member 135 includes a current probe for measuring the electrical current flowing through actuator 15 and a voltage probe for measuring the voltage applied to actuator 15. A data acquisition board 140 is connected to signal conditioning circuitry 125, sensing member 135, high voltage power supply 130, and pressure regulator 100. A computer 145 receives the various signals via data acquisition board 140 and determines various performance properties of actuator 15. Also, computer 145 controls high voltage power supply 130 and pressure regulator 100 via data acquisition board 140. A plotter 150 and a printer 155 are connected to computer 145 for displaying test results.

It will be described below that a method for measuring the piezoelectric constant of the multilayer actuator by using the testing apparatus.

At first, the various test instruments such as load member 110, optic member 120, etc., which are associated with the piezoelectric constant, are initialized before the piezoelectric constant of the piezoelectric actuator 15 is measured. That is, no force or load is applied to actuator 15, amplifier 115 is adjusted to control the magnitude of the force signal, $F_n$, to zero, and signal conditioning circuitry 125 associated with optic sensor 85 is initialized. Next, pneumatic cylinder 60 applies a predetermined force, for example 250lbs., onto actuator 15. High voltage power supply 130 initially applies a voltage of 200V for a predetermined time of five seconds to actuator 15. Computer 145 controls high voltage power supply 130 to incrementally deliver voltages to actuator 15 at 100V increments up to 900V. The magnitude of the voltage delivered to actuator 15 is represented by a signal, $V_m$. Actuator 15 displaces a predetermined amount with each incremental increase in voltage. Optical sensor member 120 determines the axial displacement of actuator 15 and responsively delivers the position signal, $L_m$, to computer 145, at each incremental change in voltage. Computer 145 acquires the test data and plots the data for later analysis. Once the data is acquired, the data is ready to be analyzed and evaluated. The piezoelectric constant is determined according to the relationship:

$$\text{piezoelectric constant} = \frac{|\,L_{m=0} - L_{m=f}\,|}{|\,L_{m=0} - L_{m=f}\,|} \times 1/N$$

wherein m is an integer representing the number of measurements at each increment of applied voltage, N represents the number of active or polled piezoelectric discs, 0 represents the original value and f represents the final value.

However, in the above-described apparatus, after the predetermined force and voltage are applied to the piezoelectric actuator, the piezoelectric constant is calculated by measuring the displacement of the piezoelectric actuator according to the applied voltage. So, the piezoelectric constant measured by using the above described apparatus may vary according to the position and condition of the piezoelectric element and the arranged condition of the optic sensor member. Also, an error may occur in measuring the piezoelectric constant because the amount of displacement of the piezoelectric element is very small at a low voltage range. In addition, the construction of the apparatus may be complicated and the manufacturing cost may be high. Also, when a piezoelectric constant of single layer piezoelectric thin film is measured by using the apparatus, there may be a short in the single layer piezoelectric thin film, or a plastic deformation of the single layer piezoelectric thin film may occur. Furthermore, it is difficult to apply constant force to the whole surface of the single layer piezoelectric thin film.

Summary of the Invention

Accordingly, considering the conventional problems as described above, it is a first object of the present invention to provide a method for measuring a piezoelectric constant of thin film type piezoelectric material which can exactly measure a piezoelectric constant of a thin film type piezoelectric material by using a pneumatic loading method and by applying a constant force to the whole surface of the thin film type piezoelectric material regardless of a topology of the thin film, without causing a short in the piezoelectric material or a plastic deformation of the piezoelectric material.

Also, it is a second object of the present invention to provide an apparatus for performing the above method.

To accomplish the above first object, there is provided in the present invention a method for measuring a piezoelectric constant of a thin film type piezoelectric material comprising the steps of:

applying a pneumatic pressure to the thin film type piezoelectric material which is placed between a top electrode formed on an upper end of the thin film type piezoelectric material and a bottom electrode formed beneath a lower end of the thin film type piezoelectric material;

measuring a charge generated from the thin film type piezoelectric material through the top electrode and the bottom electrode; and

calculating the piezoelectric constant of the thin film type piezoelectric material by using the applied pressure and the meaused charge.

The step of applying the pressure to the thin film type piezoelectric material is performed after i) initializing a computing means, a pressure gauge, a charge measuring means, and a pressing means, ii) positioning the thin film type piezoelectric material on a supporting means, and iii) positioning a pressing probe above the top electrode, to cover the top electrode, and iv) operating the pressing means and opening a main valve.

The step of measuring the charge generated from the thin film type piezoelectric material through the top electrode and the bottom electrode is performed after adjusting a release valve in order to change the applied pressure while the main valve is open. The step of calculating the piezoelectric constant of the thin film type piezoelectric material is performed by using the computing means after recording a magnitude of the measured charge in the computing means and recording a magnitude of the applied pressure in the computing means.

The step of calculating the piezoelectric constant of the thin film type piezoelectric material is performed according to the relationship:

$$\text{piezoelectric constant} = \left(\frac{\partial D}{\partial P}\right) = \frac{Q/A}{F/A} = Q/F$$

where in D represents a charge density, F represents the magnitude of the applied pressure, P represents a stress caused by F, Q represents the magnitude of the charge generated from the thin film type piezoelectric material, and A represents an area of the thin film type piezoelectric material.

In order to accomplish the above second object, there is provided in the present invention an apparatus for measuring a piezoelectric constant of a thin film type piezoelectric material comprising:

a pressing means for applying a pneumatic pressure to the thin film type piezoelectric material through a pressing probe adjacent to the thin film type piezoelectric material, the thin film type piezoelectric material being placed between a top electrode formed on an upper end of the thin film type piezoelectric material and a bottom electrode formed beneath a lower end of the thin film type piezoelectric material, and for maintaining the applied pressure during measuring of the piezoelectric constant of the thin film type piezoelectric material through the pressing probe;

a charge measuring means for measuring a charge generated from the thin film type piezoelectric material through the top electrode and the bottom electrode, the charge measuring means having a first terminal connected to the top electrode and a second terminal connected to the bottom electrode; and

a computing means for controlling the charge measuring means, and for calculating the piezoelectric constant of the thin film type piezoelectric material using the applied pressure and the measured charge.

The apparatus for measuring the piezoelectric constant of the thin film type piezoelectric material has a supporting means for supporting the thin film type piezoelectric material, and the supporting means is a substrate holder.

The apparatus for measuring the piezoelectric constant has a pressure gauge for displaying and measuring the applied pressure. The pressure gauge is connected to the pressing means. The apparatus for measuring the piezoelectric constant has a pressure control means for controlling the applied pressure. The pressure control means is connected to the pressing means and to the pressure gauge.

The pressure control means has a release valve for changing the applied pressure to the thin film type piezoelectric material in order to measure the piezoelectric constant of the thin film type piezoelectric material. The release valve has a first pipe connected to the pressing probe and to the pressure gauge, and a second pipe connected to the pressing means and to the supporting means. Also, the pressure control means has a main valve for controlling the applied pressure to the thin film type piezoelectric material. The main valve is connected to the pressing means and to the supporting means.

Preferably, the pressing means is a vacuum pump or a compressor. The charge measuring means is a charge amplifier or a picoammeter.

Therefore, according to the present invention, a uniform force can be applied to the thin film type piezoelectric material without considering a topology of the piezoelectric material because the force resulting from a uniform vacuum pressure or a uniform gas pressure, can be applied to the piezoelectric material. Also, a short in the thin film type piezoelectric material or a plastic deformation of the thin film type piezoelectric can be prevented. Also, the charge measuring device can prevent an error in the measurement of the charge generated from the piezoelectric material.

Brief Description of the Drawings

The above object and advantages of the present invention will become more apparent by describing in detail preferred embodiments thereof with reference to the attached drawings, in which:

FIG. 1 is a binary phase diagram of PZT;
FIG. 2 is a cross sectional view for showing the conventional apparatus for testing piezoelectric properties of multilayer piezoelectric actuator;
FIG. 3 shows a block diagram of the control circuitry associated with the testing apparatus;
FIG. 4 illustrates an apparatus for measuring a piezoelectric constant of a thin film type piezoelectric material according to a first embodiment of the present invention; and
FIG. 5 illustrates an apparatus for measuring a piezoelectric constant of a thin film type piezoelectric material according to a second embodiment of the present invention.

Detailed Description of the Invention

Hereinafter, the preferred embodiments of the present invention will be explained in more detail with reference to the accompanying drawings.

Embodiment 1

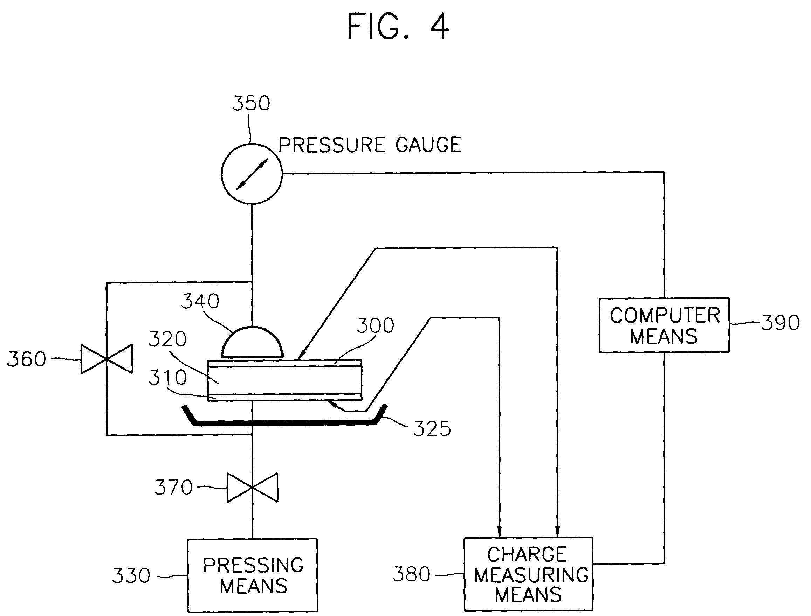

FIG. 4 illustrates an apparatus for measuring a piezoelectric constant of a thin film type piezoelectric material according to a first embodiment of the present invention.

Referring to FIG. 4, the apparatus for measuring a piezoelectric constant of a thin film type piezoelectric material, has a thin film type piezoelectric material 320, a supporting member 325, a pressing member 330, a pressing probe 340, a pressure gauge 350, a main valve 370, a release valve 360, a charge measuring member 380, and a computing member 390.

Thin film type piezoelectric material 320 is placed between a top electrode 300 formed on an upper end of piezoelectric material 320 and a bottom electrode 310 formed beneath a lower end of piezoelectric material 320. Supporting member 325 supports thin film type piezoelectric material 320. Pressing member 330 applies a predetermined pressure to thin film type piezoelectric material 320 through pressing probe 340 which is adjacent to piezoelectric material 320. The pressure is applied through pressing probe to thin film type piezoelectric material 320 and maintained for a predetermined time. Pressure gauge 350 is connected to pressing probe 340. Pressure gauge 350 displays the applied pressure and measures the applied pressure. Main valve 370 is connected to pressing member 330 and to supporting member 325. Main valve 370 controls the applied pressure. Release valve 360 has a first pipe connected to pressing probe 340 and to pressure gauge 350, and a second pipe connected to main valve 370 and to supporting member 325. When the applied pressure reduces or increases, the piezoelectric constant of thin film type piezoelectric material 320 can be measured by using release valve 360. Charge measuring member 380 has a first terminal connected to bottom electrode 310 and a second terminal connected to top electrode 300. Charge measuring member 380 measures a magnitude of charge generated from thin film type piezoelectric material 320 through top electrode 300 and bottom electrode 310. Computing member 390 has a first terminal connected to pressure gauge 350 and a second terminal connected to charge measuring member 380. Computing member 390 controls the above-described elements and calculates the piezoelectric constant of thin film type piezoelectric material 320.

A method for measuring the piezoelectric constant of the thin film type piezoelectric material by using the apparatus according to the first embodiment of the present invention will be described.

In the conventional method, a magnitude of displacement of a piezoelectric material is measured in order to calculate a piezoelectric constant of the piezoelectric material after a predetermined voltage is applied to the piezoelectric material. However, in the first embodiment of the present invention, a pneumatic loading method is used as a method for measuring a piezoelectric constant of a thin film type piezoelectric material. In the pneumatic method, the piezoelectric constant is calculated by measuring a magnitude of charge generated from the piezoelectric material after a predetermined pressure is applied to the piezoelectric material.

In order to measure the piezoelectric constant of thin film type piezoelectric material 320, computing member 390, pressure gauge 350, charge measuring member 380, and pressing member 330 are initialized before a pressure is applied to thin film type piezoelectric material 320. Next, after thin film type piezoelectric material 320 which is interposed between top electrode 300 and bottom electrode 310 is positioned on a predetermined position in supporting member 325. Pressing probe 340 is positioned above top electrode 300, to cover top electrode 300. Preferably, supporting member 325 is a substrate holder. Top electrode 300 formed on the upper end of thin film type piezoelectric material 320 is connected to the first terminal of charge measuring member 380, and bottom electrode 310 formed beneath the lower end of thin film type piezoelectric material 320 is connected to the second terminal of charge measuring member 380, in order to measure the magnitude of charge generated from piezoelectric material 320. Hence, charge measuring member 380 measures the charge generated from piezoelectric material 320 through top electrode 300 and bottom electrode 310. As charge measuring member 380, a charge amplifier or a picoammeter may be used.

After pressing member 330 is operated, main valve 370 is opened so as to apply the predetermined pressure to piezoelectric material 320. Preferably, pressing member 330 is a vacuum pump or a compressor. Release valve 360 is operated in order to change the applied pressure to piezoelectric material 320. When the applied pressure is changed, the magnitude of charge generated from piezoelectric material 320 is measured by using charge measuring member 380, and the magnitude of charge is recorded in computing member 390. At the same time, computing member 390 records the magnitude of the applied pressure from pressure gauge 350. That is, when the predetermined pressure is applied to piezoelectric material 320 from pressing member 330 through main valve 370, release valve 360, and pressing probe 340, the charge generated from piezoelectric material 320 is measured by charge measuring member 380 through top electrode 300, bottom electrode 310, and the first and the second terminals of charge measuring member 380. The magnitude of the measured charge is recorded in computing member 390. The magnitude of the applied pressure is numerically indicated by pressure gauge 350, so the magnitude of the applied pressure is adjusted by using pressure gauge 350.

When release valve 360 changes the magnitude of the applied pressure, the magnitude of the charge generated from piezoelectric material 320 is variable. Charge measuring member 380 measures this magnitude of the charge, and transfers the measured magnitude of the charge to computing member 390. When the vacuum pump is used as pressing member 330, a vacuum pressure can be applied to piezoelectric material. Also, when a compressor is used as pressing member 330, a high pressure can be applied to piezoelectric material 320. Therefore, the range of applied pressure is increased, so an exact measurement is possible.

In the conventional apparatus, it is difficult to apply uniform force to a piezoelectric material having a thin thickness and a tough surface condition because the force is mechanically applied to the piezoelectric material by using the load cell. When the force is applied, a short may occur in the thin piezoelectric material or a plastic deformation of the thin film piezoelectric material may occur. Hence, it is difficult to exactly measure the piezoelectric constant of the piezoelectric material as an error may occur when the piezoelectric constant is measured. Furthermore, when the piezoelectric constant is calculated by using the optic sensor means in order to measure the displacement of the multilayer piezoelectric actuator, the value of the piezoelectric constant may vary according to the array and the condition of the optic sensor and the multilayer piezoelectric actuator. Also, when the applied voltage is low, an error in the measured piezoelectric constant may occur because the displacement of the multilayer piezoelectric actuator is very small.

In the first embodiment of the present invention, however, a uniform force can be applied to the thin film type piezoelectric material without considering a topology of the piezoelectric material because the force resulting from a uniform vacuum pressure or a uniform gas pressure, can be applied to the piezoelectric material. Also, a short in the thin film type piezoelectric material or a plastic deformation of the thin film type piezoelectric can be prevented. Charge measuring member 380 can prevent an error in the measurement of the charge generated from the piezoelectric material.

Computing member 380 calculates the piezoelectric constant based on the measured magnitudes of the charge and the pressure according to the relationship:

$$\text{piezoelectric constant} = \left( \frac{\partial D}{\partial P} \right) = \frac{Q/A}{F/A} = Q/F$$

wherein D represents a charge density, F represents an applied force (that is, a vacuum force or a gas force), P represents a stress caused by F, Q represents the magnitude of the charge generated from the piezoelectric material, and A represents an area of the piezoelectric material. For example, when the applied force is changed from 760torr to 0torr, the area of the piezoelectric material having a diameter of 10mm is $7.85 \times 10^{-5} m^2$, and the magnitude of the measured charge is 0.8nF, the piezoelectric constant is about 100pC/N according to the above relationship.

Embodiment 2

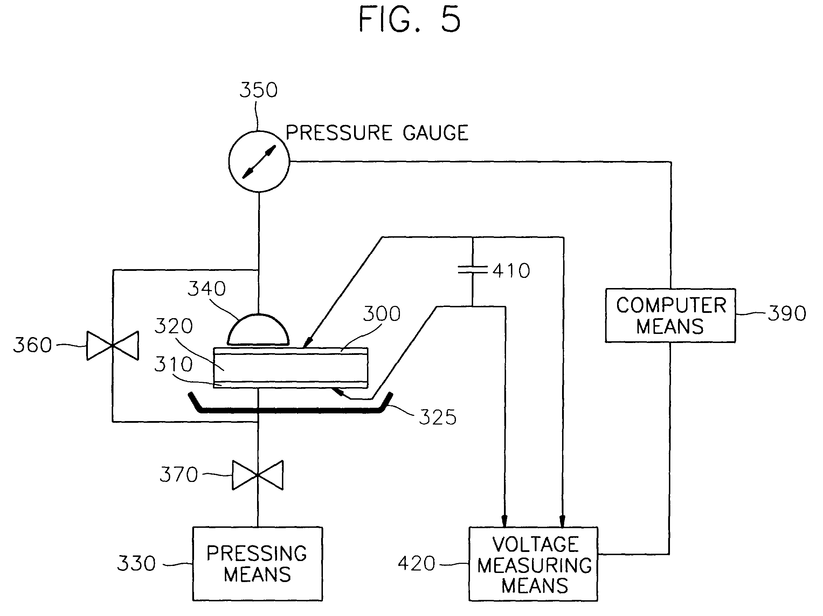

FIG. 5 illustrates an apparatus for measuring a piezoelectric constant of a thin film type piezoelectric material according to a second embodiment of the present invention. The elements in FIG. 5 have the same reference numerals as in FIG. 4. Referring to FIG. 5, the apparatus for measuring a piezoelectric constant of a thin film type piezoelectric material, has a thin film type piezoelectric material 320, a supporting member 325, a pressing member 330, a pressing probe 340, a pressure gauge 350, a main valve 370, a release valve 360, a capacitor 410, a voltage measuring member 420, and a computing member 390.

Thin film type piezoelectric material 320 is placed between a top electrode 300 formed on an upper end of piezoelectric material 320 and a bottom electrode 310 formed beneath a lower end of piezoelectric material 320. Supporting member 325 supports thin film type piezoelectric material 320. Pressing member 330 applies a predetermined pressure to thin film type piezoelectric material 320 through pressing probe 340 which is adjacent to piezoelectric material 320. The pressure is applied through pressing probe 340 to thin film type piezoelectric material 320 and is maintained for a predetermined time. Pressure gauge 350 is connected to pressing probe 340. Pressure gauge 350 displays the applied pressure and measures the applied pressure. Main valve 370 is connected to pressing member 330 and to supporting member 325. Main valve 370 controls the applied pressure. Release valve 360 has a first pipe connected to pressing probe 340 and to pressure gauge 350, and a second pipe connected to main valve 370 and to supporting member 325. When the applied pressure reduces or increases, the piezoelectric constant of thin film type piezoelectric material 320 to be measured can be measured by using release valve 360. Capacitor 410 has a first terminal connected to bottom electrode 310 formed beneath the lower end of thin film type piezoelectric material 320 and a second terminal connected to top electrode 300 formed on the upper end of piezoelectric material 320. Capacitor 410 maintains a constant electric field in piezoelectric material 320. Capacitor 410 has a first terminal connected to top electrode 300 and a second terminal connected to bottom electrode 310. Voltage measuring member 420 is connected in parallel to capacitor 410. Voltage measuring member 420 measures the magnitude of a voltage caused by a charge generated from thin film type piezoelectric material 320. Computing member 390 has a first terminal connected to pressure gauge 350 and a second terminal connected to voltage measuring member 420. Computer 390 controls the above-described elements and calculates the piezoelectric constant of thin film type piezoelectric material 320.

A method for measuring the piezoelectric constant of the thin film type piezoelectric material by using the apparatus according to the second embodiment of the present invention will be described.

In the second embodiment of the present invention, the pneumatic loading method is used as a method for measuring a piezoelectric constant of a thin film type piezoelectric material. Pneumatic loading method is used as a method for measuring a piezoelectric constant of a thin film type piezoelectric material. In the pneumatic method, the piezoelectric constant is calculated by measuring a magnitude of charge generated from the piezoelectric material after a predetermined pressure is applied to the piezoelectric material.

In order to measure the piezoelectric constant of thin film type piezoelectric material 320, computing member 390, pressure gauge 350, voltage measuring member 380, capacitor 410, and pressing member 330 are initialized before a pressure is applied to thin film type piezoelectric material 320 placed between top electrode 300 and bottom electrode 310. Next, after thin film type piezoelectric material 320 placed between top electrode 300 and bottom electrode 310 is positioned on a predetermined position in supporting member 325. Pressing probe 340 is positioned above top electrode 300, to cover top electrode 300. Preferably, supporting member 325 is a substrate holder. Top electrode 300 formed on the upper end of thin film type piezoelectric material 320 is connected to the first terminal of capacitor 410, and bottom electrode 310 is connected to the second terminal of capacitor 410, in order to maintain a constant electric field in the thin film type piezoelectric material 320. Voltage measuring member 420 connected in parallel to capacitor 410 measures the magnitude of the voltage caused by the charge generated from piezoelectric material 320. Preferably, voltage measuring member 420 is a volt meter. That is, voltage measuring member 420 measures the magnitude of the voltage caused by the charge generated from piezoelectric material 320 by measuring the voltage of capacitor 410. In this case, capacitor 410 has a larger capacitance than a capacitance of the piezoelectric material 320, so capacitor 410 uniformly maintains the electric field in piezoelectric material 320.

After pressing member 330 is operated, main valve 370 is opened so as to apply the predetermined pressure to piezoelectric material 320. Preferably, pressing member 330 is a vacuum pump or a compressor. Release valve 360 is operated in order to change the applied pressure to piezoelectric material 320. When the applied pressure is changed, the magnitude of the voltage caused by the charge generated from piezoelectric material 320 is measured by using voltage measuring member 420 through capacitor 410, and the magnitude of the voltage is recorded in computing member 390. At the same time, computing member 390 records the magnitude of the applied pressure from pressure gauge 350. That is, when the predetermined pressure is applied to piezoelectric material 320 from pressing member 330 through main valve 370, release valve 360, and pressing probe 340, the voltage caused by the charge generated from piezoelectric material 320 is measured by voltage measuring member 380 through capacitor 410 connected in parallel to voltage measuring member 420. The magnitude of the measured voltage is recorded in computer 390. The magnitude of the applied pressure is numerically indicated by pressure gauge 350, so the magnitude of the applied pressure is adjusted.

When release valve 360 changes the magnitude of the applied pressure, the magnitude of the voltage caused by the charge generated from piezoelectric material 320 varies. Voltage measuring member 420 measures this magnitude of the voltage through capacitor 410, and transfers the magnitude of the voltage to computing member 390. When the vacuum pump is used as pressing member 330, a vacuum pressure can be applied to piezoelectric material. Also, when a compressor is used as pressing member 330, a high gas pressure can be applied to piezoelectric material 320. Therefore, the range of the applied pressure is increased, so an exact measurement can be performed.

In the conventional apparatus, it is difficult to apply uniform force to a piezoelectric material having a thin thickness and a tough surface condition because the force is applied to the piezoelectric material by using the load cell. When the force is applied, a short in the thin piezoelectric material may occur, or a plastic deformation of the thin piezoelectric material may occur. Hence, it is difficult to exactly measure the piezoelectric constant of the piezoelectric material, and an error may occur when the piezoelectric constant is measured. Furthermore, when the piezoelectric constant is calculated by using the optic sensor means in order to measure the displacement of the multilayer piezoelectric actuator, the value of the piezoelectric constant may vary according to the array and the condition of the optic sensor means and the multilayer piezoelectric actuator. When the applied voltage is low, an error in the measured piezoelectric constant may occur because the displacement of the multilayer piezoelectric actuator is very small.

In the second embodiment of the present invention, however, a uniform force such as the vacuum pressure or the high gas pressure can be applied to the thin film type piezoelectric material without considering a topology of the piezoelectric material because the force resulting from the uniform vacuum pressure or the uniform gas pressure can be applied to the piezoelectric material. Also, the short in the thin film piezoelectric material or the plastic deformation of the thin film type piezoelectric can be prevented. And, the voltage measuring member and the capacitor can prevent an error in the measurement of the voltage caused by the charge generated from the piezoelectric material.

Computing member 380 calculates the piezoelectric constant based on the measured magnitudes of the voltage and the pressure according to the relationship:

$$\text{piezoelectric constant} = \left(\frac{\partial D}{\partial P}\right) = \frac{Q/A}{F/A} = Q/F = CV/F$$

where D represents a charge density, F represents an applied force(that is, a vacuum force or a gas force), P represents a stress caused by F, Q represents the magnitude of the charge generated from the piezoelectric material, A represents an area of the piezoelectric material, C represents the capacitance of a capacitor, and V represents the magnitude of the measured voltage. For example, when the applied force is changed from 760torr to 0torr, the area of the piezoelectric material having a diameter of 10mm is $7.85 \times 10^{-5} \text{m}^2$, the capacitance of the capacitor is $1.0\mu\text{F}$, and the measured voltage is 0.8mV, the piezoelectric constant is about 100pC/N according to the above relationship.

Although preferred embodiments of the present invention have been described, it is understood that the present invention should not be limited to this preferred embodiments, but various changes and modifications can be made by one skilled in the art within the spirit and scope of the invention as hereinafter claimed.

**Claims**

1. A method for measuring a piezoelectric constant of a thin film type piezoelectric material comprising the steps of:

   applying a pneumatic pressure to the thin film type piezoelectric material which is placed between a top electrode formed on an upper end of the thin film type piezoelectric material and a bottom electrode formed beneath a lower end of the thin film type piezoelectric material;
   measuring a charge generated from the thin film type piezoelectric material through said top electrode and said bottom electrode; and
   calculating the piezoelectric constant of the thin film type piezoelectric material using the applied pressure and the measured charge.

2. The method for measuring a piezoelectric constant of a thin film type piezoelectric material as claimed in claim 1, wherein the step of applying a pressure to a thin film type piezoelectric material is performed after i) initializing a computing means, a pressure gauge, a charge measuring means, and a pressing means, ii) positioning the thin film type piezoelectric material on a supporting means, and iii) positioning a pressing probe above said top electrode to cover the top electrode, and iv) operating said pressing means and opening a main valve.

3. The method for measuring a piezoelectric constant of a thin film type piezoelectric material as claimed in claim 2, wherein the step of measuring a charge generated from the thin film type piezoelectric material through said top electrode and said bottom electrode is performed after adjusting a release valve in order to change the applied pressure while said main valve is open.

4. The method for measuring a piezoelectric constant of a thin film type piezoelectric material as claimed in claim 3, wherein the step of calculating the piezoelectric constant of the thin film type piezoelectric material is performed by using said computing means after recording a magnitude of the measured charge in said computing means and recording a magnitude of the applied pressure in said computing means.

5. The method for measuring a piezoelectric constant of a thin film type piezoelectric material as claimed in claim 1, wherein the step of calculating the piezoelectric constant of the thin film type piezoelectric material is performed according to the relationship:

$$\text{piezoelectric constant} = \left(\frac{\partial D}{\partial P}\right) = \frac{Q/A}{F/A} = Q/F$$

   where in D represents a charge density, F represents the magnitude of the applied pressure, P represents a stress caused by F, Q represents the magnitude of the charge generated from the thin film type piezoelectric material, and A represents an area of the thin film type piezoelectric material.

6. A method for measuring a piezoelectric constant of a thin film type piezoelectric material comprising the steps of:

   initializing a computing means, a pressure gauge, a charge measuring means, and a pressing means;
   positioning a thin film type piezoelectric material on a supporting means, the thin film type piezoelectric material being placed between a top electrode formed on an upper end of the thin film type piezoelectric material and a bottom electrode formed beneath a lower end of the thin film type piezoelectric material;
   positioning a pressing probe above said top electrode, to cover said top electrode;
   operating said pressing means in order to apply a pneumatic pressure to the thin film type piezoelectric material, and opening a main valve, said pressing means being connected to said pressing probe and said main valve being connected to said pressing means and to said supporting means;
   applying the pneumatic pressure to the thin film type piezoelectric material from said pressing means through said pressing probe;
   adjusting a release valve in order to change the applied pressure while said main valve is open, said release valve having a first pipe connected to said pressing probe and to said pressure gauge, and a second pipe connected to said main valve and to said supporting means;
   measuring a charge generated from the thin film type piezoelectric material through said top electrode and said bottom electrode by using said charge measuring means having a first terminal and a second terminal respectively connected to said top electrode and to said bottom electrode;

recording a magnitude of the measured charge in said computing means;

recording a magnitude of the applied pressure in said computing means; and

calculating the piezoelectric constant of the thin film type piezoelectric material from the recorded magnitude of the measured charge and the recorded magnitude of the applied pressure by using said computing means.

7. The method for measuring a piezoelectric constant of a thin film type piezoelectric material as claimed in claim 6, wherein the step of recording a magnitude of the measured charge in said computing means and the step of recording a magnitude of the applied pressure in said computing means are simultaneously performed.

8. The method for measuring a piezoelectric constant of a thin film type piezoelectric material as claimed in claim 6, wherein the step of calculating the piezoelectric constant of the thin film type piezoelectric material is performed according to the relationship:

$$\text{piezoelectric constant} = \left(\frac{\partial D}{\partial P}\right) = \frac{Q/A}{F/A} = Q/F$$

where in D represents a charge density, F represents the magnitude of the applied pressure, P represents a stress caused by F, Q represents the magnitude of the charge generated from the thin film type piezoelectric material, and A represents an area of the thin film type piezoelectric material.

9. A method for measuring a piezoelectric constant of a thin film type piezoelectric material comprising the steps of:

initializing a computing means, a pressure gauge, a voltage measuring means, and a pressing means;

positioning a thin film type piezoelectric material on a supporting means, the thin film type piezoelectric material being placed between a top electrode formed on an upper end of the thin film type piezoelectric material and a bottom electrode formed beneath a lower end of the thin film type piezoelectric material;

positioning a pressing probe above said top electrode, to cover said top electrode;

operating said pressing means in order to apply a pneumatic pressure to the thin film type piezoelectric material, and opening a main valve, said pressing means being connected to said pressing probe and said main valve being connected to said pressing means and to said supporting means;

applying the pneumatic pressure to the thin film type piezoelectric material from said pressing means through said pressing probe;

adjusting a release valve in order to change the applied pressure while said main valve is open, said release valve having a first pipe connected to said pressing probe and to said pressure gauge and a second pipe connected to said main valve and to said supporting means;

maintaining a constant electric field in the thin film type piezoelectric material by using a capacitor having a first terminal connected to said top electrode and a second terminal connected to said bottom electrode;

measuring a voltage caused by a charge generated from the thin film type piezoelectric material through said capacitor by using said voltage measuring means being connected in parallel to said capacitor;

recording a magnitude of the measured voltage in said computing means;

recording a magnitude of the applied pressure in said computing means; and

calculating the piezoelectric constant of the thin film type piezoelectric material from the recorded magnitude of the measured voltage and the recorded magnitude of the applied pressure by using said computing means.

10. The method for measuring a piezoelectric constant of a thin film type piezoelectric material as claimed in claim 9, wherein the step of maintaining a constant electric field in the thin film type piezoelectric material is performed by using said capacitor having a larger capacitance than a capacitance of the thin film type piezoelectric material.

11. The method for measuring a piezoelectric constant of a thin film type piezoelectric material as claimed in claim 9, wherein the step of recording a magnitude of the measured voltage in said computing means and the step of recording a magnitude of the applied pressure in said computing means are simultaneously performed.

12. The method for measuring a piezoelectric constant of a thin film type piezoelectric material as claimed in claim 9, wherein the step of calculating the piezoelectric constant of the thin film type piezoelectric material is performed according to the relationship:

$$\text{piezoelectric constant} = \left(\frac{\partial D}{\partial P}\right) = \frac{Q/A}{F/A} = Q/F = CV/F$$

where D represents a charge density, F represents the magnitude of an applied pressure, P represents a stress caused by F, Q represents the magnitude of the voltage caused by the charge generated from the thin film type piezoelectric material, A represents an area of the thin film type piezoelectric material, C represents the capacitance of said capacitor, and V represents the magnitude of the measured voltage.

13. An apparatus for measuring a piezoelectric constant of a thin film type piezoelectric material comprising:

a pressing means for applying a pneumatic pressure to a thin film type piezoelectric material through a pressing probe adjacent to the thin film type piezoelectric material, the thin film type piezoelectric material being placed between a top electrode formed on an upper end of the thin film type piezoelectric material and a bottom electrode formed beneath a lower end of the thin film type piezoelectric material, and for maintaining the applied pressure during measuring of the piezoelectric constant of the thin film type piezoelectric material through said pressing probe;
a charge measuring means for measuring a charge generated from the thin film type piezoelectric material through said top electrode and said bottom electrode, said charge measuring means having a first terminal connected to said top electrode and a second terminal connected to said bottom electrode; and
a computing means for controlling said charge measuring means, and for calculating the piezoelectric constant of the thin film type piezoelectric material using the applied pressure and the measured charge.

14. The apparatus for measuring a piezoelectric constant of a thin film type piezoelectric material claimed as claim 13, further comprising a supporting means for supporting the thin film type piezoelectric material.

15. The apparatus for measuring a piezoelectric constant of a thin film type piezoelectric material as claimed in claim 14, wherein said supporting means is a substrate holder.

16. The apparatus for measuring a piezoelectric constant of a thin film type piezoelectric material as claimed in claim 14, further comprising:

a pressure gauge for displaying and measuring the applied pressure, said pressure gauge being connected to said pressing means; and
a pressure control means for controlling the applied pressure, said pressure control means being connected to said pressing means and to said pressure gauge.

17. The apparatus for measuring a piezoelectric constant of a thin film type piezoelectric material as claimed in claim 16, wherein said pressure control means comprising:

a release valve for changing the applied pressure to the thin film type piezoelectric material in order to measure the piezoelectric constant of the thin film type piezoelectric material, said release valve having a first pipe connected to said pressing probe and to said pressure gauge and a second pipe connected to said pressing means and to said supporting means; and
a main valve for controlling the applied pressure to the thin film type piezoelectric material, said main valve being connected to said pressing means and to said supporting means.

18. The apparatus for measuring a piezoelectric constant of a thin film type piezoelectric material as claimed in claim 13, wherein said pressing means is a vacuum pump.

19. The apparatus for measuring a piezoelectric constant of a thin film type piezoelectric material as claimed in claim 13, wherein said pressing means is a compressor.

20. The apparatus for measuring a piezoelectric constant of a thin film type piezoelectric material as claimed in claim 13, wherein said charge measuring means is a charge amplifier.

21. The apparatus for measuring a piezoelectric constant of a thin film type piezoelectric material as claimed in claim 13, wherein said charge measuring means is a picoammeter.

**22.** An apparatus for measuring a piezoelectric constant of a thin film type piezoelectric material comprising:

a supporting means for supporting a thin film type piezoelectric material placed between a top electrode formed on an upper end of the thin film type piezoelectric material and a bottom electrode formed beneath a lower end of the thin film type piezoelectric material;

a pressing means for applying a pneumatic pressure to the thin film type piezoelectric material through a pressing probe which is adjacent to the thin film type piezoelectric material, and for maintaining the applied pressure during measuring of the piezoelectric constant of the thin film type piezoelectric constant through said pressing probe;

a main valve for controlling the applied pressure to the thin film type piezoelectric material, said main valve being connected to said pressing means and to said supporting means;

a pressure gauge for displaying and measuring the applied pressure, said pressure gauge being connected to said pressing probe;

a release valve for changing the applied pressure to the thin film type piezoelectric material in order to measure the piezoelectric constant of the thin film type piezoelectric material, said release valve having a first pipe connected to said pressing probe and to said pressure gauge and a second pipe connected to said main valve and to said supporting means;

a charge measuring means for measuring a charge generated from the thin film type piezoelectric material through said top electrode and said bottom electrode, said charge measuring means having a first terminal connected to said top electrode and a second terminal connected to said bottom electrode; and

a computing means for controlling said pressure gauge and said charge measuring means, and for calculating the piezoelectric constant of the thin film type piezoelectric material using the measured pressure and the measured voltage, said computer being connected to said pressure gauge and to said charge measuring means.

**23.** The apparatus for measuring a piezoelectric constant of a thin film type piezoelectric material as claimed in claim 22, wherein said supporting means is a substrate holder.

**24.** The apparatus for measuring a piezoelectric constant of a thin film type piezoelectric material as claimed in claim 22, wherein said pressing means is a vacuum pump or a compressor.

**25.** The apparatus for measuring a piezoelectric constant of a thin film type piezoelectric material as claimed in claim 22, wherein said charge measuring means is a charge amplifier or a picoammeter.

**26.** An apparatus for measuring a piezoelectric constant of a thin film type piezoelectric material comprising:

a supporting means for supporting a thin film type piezoelectric material placed between a top electrode formed on an upper end of the thin film type piezoelectric material and a bottom electrode formed beneath a lower end of the thin film type piezoelectric material;

a pressing means for applying a pneumatic pressure to the thin film type piezoelectric material through a pressing probe which is adjacent to the thin film type piezoelectric material, and for maintaining the applied pressure during measuring of the piezoelectric constant of the thin film type piezoelectric constant through said pressing probe;

a main valve for controlling the applied pressure to the thin film type piezoelectric material, said main valve being connected to said pressing means and to said supporting means;

a pressure gauge for displaying and measuring the applied pressure, said pressure gauge being connected to said pressing probe;

a release valve for changing the applied pressure to the thin film type piezoelectric material in order to measure the piezoelectric constant of the thin film type piezoelectric material, said release valve having a first pipe connected to said pressing probe and to said pressure gauge and a second pipe connected to said main valve and to said supporting means;

a capacitor for maintaining a constant electric field in the thin film type piezoelectric material, said capacitor having a first terminal connected to said top electrode and a second terminal connected to said bottom electrode;

a voltage measuring means for measuring a voltage caused by a charge generated from the thin film type piezoelectric material, said voltage measuring means being connected in parallel to said capacitor; and

a computing means for controlling said pressure gauge and said charge measuring means, and for calculating the piezoelectric constant of the thin film type piezoelectric material using the measured pressure and the measured voltage, said computer being connected to said pressure gauge and to said voltage measuring means.

27. The apparatus for measuring a piezoelectric constant of a thin film type piezoelectric material claimed as claim 26, wherein said supporting means is a substrate holder.

28. The apparatus for measuring a piezoelectric constant of a thin film type piezoelectric material claimed as claim 26, wherein said pressing means is a vacuum pump or a compressor.

29. The apparatus for measuring a piezoelectric constant of a thin film type piezoelectric material claimed as claim 26, wherein said capacitor has a larger capacitance than a capacitance of the thin film type piezoelectric material.

30. The apparatus for measuring a piezoelectric constant of a thin film type piezoelectric material claimed as claim 26, wherein said voltage measuring means is a voltmeter.

# FIG. 1
## (PRIOR ART)

# FIG. 2
## (PRIOR ART)

FIG. 3
(PRIOR ART)

PLOTTER — 150

PRINTER — 155

COMPUTER MEANS — 145

SIGNAL CONDITIONING CIRCUITRY — 120

AMPLIFIER — 110

125

DATA ACQUISITION BOARD — 140

POWER SUPPLY — 130

SENSING MEANS — 135

PRESSURE REGULATOR — 100

115

105

10

# FIG. 4

EP 0 846 954 A1

# FIG. 5

EP 0 846 954 A1

European Patent
Office

**EUROPEAN SEARCH REPORT**

Application Number

EP 96 11 9596

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y,D | JOURNAL OF APPLIED PHYSICS, vol. 76, no. 3, 1 August 1994, US, pages 1764-1767, XP000444966 LEFKI K ET AL: "MEASUREMENT OF PIEZOELECTRIC COEFFICIENTS OF FERROELECTRIC THIN FILMS" * page 1764, right-hand column, paragraph 2 - page 1765, left-hand column, paragraph 2; figure 1 * * page 1765, left-hand column, paragraph 4 - right-hand column, paragraph 1 * --- | 1-30 | G01R29/22 |
| Y,D | US 5 301 558 A (LIVINGSTON JEFFREY A ET AL) 12 April 1994 * abstract; figures * * column 1, line 30 - line 43 * * column 1, line 53 - line 67 * --- | 1-30 | |
| A | PROCEEDINGS OF THE WORKSHOP ON MICRO ELECTRO MECHANICAL SYSTEMS INVESTIGATION OF MICRO STRUCTURES, SENSORS, ACTUATORS, MACHINES AND ROBOTS, NARA, JP., JAN. 30 - FEB. 2, 1991, pages 114-119, XP000295553 TJHEN W: "PROPERTIES OF PIEZOELECTRIC THIN FILMS FOR MICROMECHANICAL DEVICES AND SYSTEMS" * page 116, right-hand column - page 117, left-hand column; figures 2,7 * --- -/-- | 1,6,9, 13,22,26 | TECHNICAL FIELDS SEARCHED (Int.Cl.6) G01N G01R |

The present search report has been drawn up for all claims

| Place of search | Date of completion of the search | Examiner |
|---|---|---|
| BERLIN | 7 May 1997 | Fritz, S |

European Patent Office

**EUROPEAN SEARCH REPORT**

Application Number

EP 96 11 9596

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | REVIEW OF SCIENTIFIC INSTRUMENTS, vol. 58, no. 8, August 1987, US, pages 1514-1517, XP002030650 A.AMIN: "Computer-controlled system for investigating the hydrostatic piezoresistive effect as a function of temperature" * abstract; figures 1,2 * * page 1515, right-hand column, last line - page 1516, left-hand column, line 2 * | 3,6,9, 17,22,26 | |
| A | PATENT ABSTRACTS OF JAPAN vol. 095, no. 006, 31 July 1995 & JP 07 077552 A (MURATA MFG CO LTD), 20 March 1995, * abstract * | 1,6,9, 13,22,26 | |

TECHNICAL FIELDS SEARCHED (Int.Cl.6)

The present search report has been drawn up for all claims

| Place of search | Date of completion of the search | Examiner |
|---|---|---|
| BERLIN | 7 May 1997 | Fritz, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document